**Europäisches Patentamt**

**European Patent Office**

**Office européen des brevets**

(11) Veröffentlichungsnummer: **0 230 876 B1**

# (12) EUROPÄISCHE PATENTSCHRIFT

(45) Veröffentlichungstag der Patentschrift:
02.01.91 Patentblatt 91/01

(21) Anmeldenummer: **87100122.8**

(22) Anmeldetag: **07.01.87**

(51) Int. Cl.⁵: **H03B 5/36**

(54) Frequenzsteuerbarer Quarzoszillator.

(30) Priorität: **09.01.86 DE 3600453**

(43) Veröffentlichungstag der Anmeldung:
**05.08.87 Patentblatt 87/32**

(45) Bekanntmachung des Hinweises auf die
Patenterteilung:
**02.01.91 Patentblatt 91/01**

(84) Benannte Vertragsstaaten:
**AT BE CH DE FR GB IT LI**

(56) Entgegenhaltungen:
**EP-A- 0 014 387**
**EP-A- 0 132 749**
**GB-A- 876 052**

(56) Entgegenhaltungen:
**GB-A- 2 011 207**
**US-A- 4 520 326**
**NEW ELECTRONICS, Band 15, Nr. 20, 19.**
**Oktober 1982, Seite 21, London, GB; R.C.**
**MARMION: "Linear voltage controlled crystal**
**oscillator"**

(73) Patentinhaber: **Siemens Aktiengesellschaft**
**Wittelsbacherplatz 2**
**D-8000 München 2 (DE)**

(72) Erfinder: **Bruckböck, Peter, Dipl.-Ing.**
**Fliederstrasse 15**
**D-8899 Hohenwart (DE)**
Erfinder: **Thanhäuser, Gerhard, Dipl.-Ing.**
**Mozartstrasse 9**
**D-8905 Mering (DE)**

**Beschreibung**

Die Erfindung betrifft einen Quarzoszillator entsprechend dem Oberbegriff des Anspruchs 1.

Ein Oszillator der vorstehend geschilderten Art ist aus der DE-C- 29 04 045 (-EP-A- 0 014 387) bekannt. Der bekannte Dreipunktoszillator enthält ebenfalls eine Stromspiegelschaltung aus einem ersten Transistor und einem zweiten als Diode geschalteten Transistor, von dessen zusammengeführten Basis- und Kollektoranschluß eine erste RC-Parallelschaltung gegen Masse und eine zweite RC-Parallelschaltung zum Basisanschluß des ersten Transistors geführt ist. Zwischen diesem Basisanschluß und Masse ist eine Reihenschaltung aus einem Dämpfungswiderstand, einem Grundtonquarz, einer Induktivität und einer Varaktordiode eingeschaltet, an dem Verbindungspunkt zwischen Quarz und Induktivität kann dabei die Steuerspannung für die Schwingfrequenz des Oszillators angekoppelt werden.

Aus der US-A- 39 58 190 ist ein Colpitts-Oszillator bekannt, bei dem eine spannungsabhängige Kapazität in einer Reihenschaltung zusammen mit einer Induktivität und einem Quarz angeordnet ist.

Bekannte Quarzoszillatoren werden in Digitalsignal-Regeneratoren angewendet, wo sie im normalen Betriebsfall in PLL-Schaltungen ein zum empfangenen digitalen Signal synchrones Taktsignal erzeugen, bei Ausfall des empfangenen digitalen Signals jedoch in einen Festfrequenzbetrieb übergehen. Dadurch wird in der Übertragungsstrecke nach dem gestörten Abschnitt ein Signal übertragen, das zwar keine Information enthält, die in der Übertragungsstrecke folgenden Digitalsignal-Regeneratoren jedoch weiter synchronisiert. Der in den Festfrequenzbetrieb geschaltete Oszillator gibt ein Signal mit einer Frequenz ab, die aufgrund von Alterungs- und Temperatureinflüssen eine bestimmte Frequenztoleranz aufweist. Zur Sicherung der Synchronisation müssen also die Oszillatoren einen Ziehbereich aufweisen, der deutlich größer als die Frequenztoleranz im Festfrequenzbetrieb ist. Der bekannte Quarzoszillator weist aufgrund der Anwendung einer gemischt induktiven und kapazitiven Schwingfrequenzsteuerung bereits einen vergleichsweise hohen Ziehbereich auf, dadurch sind jedoch die Reaktanzen der verwendeten Kapazitätsdiode und der Induktivität so groß, daß deren zeitliche Inkonstanz die im Festfrequenzbetrieb erzielbare Frequenzgenauigkeit deutlich verschlechtert. Zusätzlich ist bei der Umschaltung des bekannten Quarzoszillators in den Festfrequenzbetrieb die Steuerspannung der Kapazitätsdiode auf einem festen vorgegebenen Wert zu halten an dessen Konstanz hohe Anforderungen zu stellen sind.

Die Aufgabe bei der vorliegenden Erfindung besteht also darin, einen frequenzsteuerbaren Quarzoszillator mit Umschaltemöglichkeit in einen Festfrequenzbetrieb mit hoher Frequenzkonstanz zu entwickeln, bei dem an die zeitliche Konstanz der frequenzbestimmenden Reaktanzen und der Steuerspannung keine hohen Ansprüche gestellt werden.

Die Aufgabe wird durch einen Quarzoszillator erfindungsgemäß mit den im Patentanspruch 1 angegebenen Merkmalen gelöst. Von besonderem Vorteil ist dabei, daß gleichzeitig die Auswirkung von Temperatureinflüssen auf die frequenzbestimmenden Reaktanzen deutlich verringert werden konnte und daß der Aufwand verglichen mit der bekannten Lösung nur geringfügig angestiegen ist.

Zweckmäßige Ausbildungen des erfindungsgemäßen Quarzoszillators sowie die Ausbildung einer nachgeschalteten Begrenzerstufe sind in den Patentansprüchen 2 bis 6 beschrieben.

Die Erfindung soll im folgenden anhand eines in der Zeichnung dargestellten Ausführungsbeispiels näher erläutert werden.

Das in der Figur dargestellte Ausführungsbeispiel enthält neben dem eigentlichen Oszillator einen Umschalter, durch der Oszillator entweder als frequenzsteuerbarer Quarzoszillator oder als Festfrequenz-Oszillator betrieben werden kann, außerdem ist dem Oszillator eine Begrenzerstufe nachgeschaltet. Der dargestellte Quarzoszillator enthält eine aus dem ersten und dem zweiten npn-Transistor T1, T2 gebildete Stromspiegelschaltung, die Basis- und Kollektoranschlüsse des zweiten Transistors T2 sind miteinander und über eine erste Parallelschaltung aus einem ersten Widerstand R1 und einem ersten Kondensator C1 mit Bezugspotential sowie über eine zweite Parallelschaltung aus einem zweiten Widerstand R2 und einem zweiten Kondensator C2 mit der Basis des ersten Transistors T1 verbunden. Die zusammengeführten Emitteranschlüsse des ersten und des zweiten Transistors T1, T2 sind über einen dritten Widerstand an die negative Betriebsspannung -UB angeschlossen, der Kollektor des ersten Transistors T1 ist über einen vierten Widerstand R4 mit Bezugspotential verbunden. Als frequenzbestimmendes Glied dient beim Ausführungsbeispiel die Reihenschaltung aus einer Varaktordiode D1, einer Induktivität L, einem Grundtonquarz Q sowie einem dritten Kondensator C3, der als Trimmer ausgeführt ist. Diese Reihenschaltung ist zwischen Bezugspotential und Basisanschluß des ersten Transistors T1 eingeschaltet, die Steuerspannung für die Varaktordiode D1 wird von einem Steuerspannungseingang E über einen fünften Widerstand R5 an den Verbindungspunkt zwischen der Induktivität L und dem Quarz Q geführt. Zur Umschaltung zwischen Festfrequenzbetrieb und nachziehbarem Oszillator ist der Reihenschaltung aus Varaktordiode D1 und Induktivität L eine Schottkydiode D2 parallel geschaltet, eine weitere Schottkydiode D3 sowie ein sechster Widerstand R6 sind zwischen dem Verbindungspunkt der Induktivität L und des Quarzes Q sowie der negativen Betriebsspannung -UB eingeschaltet. Am Verbindungspunkt der weiteren Schottkydiode D3 und des sechsten Widerstandes R6 ist ein vierter Kondensator C4 als Siebkondensator nach Masse gelegt, außerdem ist dieser Verbindungspunkt über einen siebenten Widerstand R7 mit dem Kollektor eines dritten Transistors T3 vom pnp-Typ verbunden. Der Basisanschluß dieses Transistors T3 wird vom Schaltspannungseingang UC über einen achten Widerstand R8 eine Schaltspannung zugeführt, der Emitteranschluß dieses Transistors T3 ist direkt mit einem Anschluß über die positive Betriebsspannung +UB sowie über einen fünften Kondensator C5 mit Bezugspotential verbunden. An den Kollektoranschluß des ersten Transistors T1 ist über einen sechsten Kondensator C6 der Begrenzer angeschlossen. Mit dem anderen Anschluß des Kondensators C6 sind unmittelbar der Basisanschluß eines vierten Transistors T4, über einen neunten Widerstand R9 der Kollektoranschluß dieses Transistors sowie über einen zehnten Widerstand R10 der Emitteranschluß dieses Transistors verbunden, der Emitteranschluß ist außerdem an die negative Betriebsspannung -UB angeschlossen, die über einen achten Kondensator C8 abgeblockt wird. Der Kollektoranschluß des vierten Transistors T4 ist über einen siebenten Kondensator C7 mit dem Ausgangsanschluß A sowie über einen elften Widerstand R11 mit Bezugspotential verbunden.

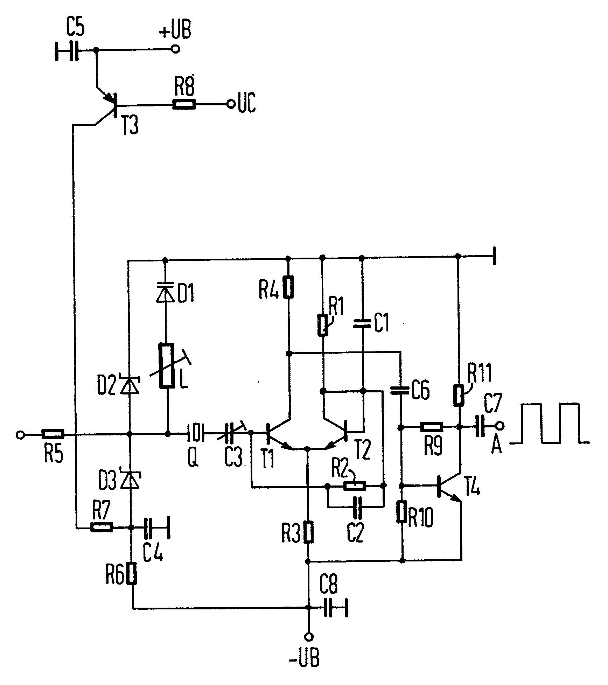

Der in der Figur dargestellte Quarzoszillator enthält also eine kapazitive Dreipunktschaltung, wie sie in Aufbau und Wirkungsweise in der Fig. 1 der DE-C-29 04 045 beschrieben ist.

Diese Dreipunktschaltung wird zunächst durch einen zusätzlichen, abgleichbaren Kondensator C3 so ergänzt, daß bei der Quarzfrequenz eine kapazitive Last entsteht, die der nominellen Lastkapazität des Quarzes gleich ist. Diese Kapazität wird näherungsweise durch die Serienschaltung des ersten, des zweiten und des dritten Kondensators C1, C2, C3 gebildet. Diese, durch den dritten Kondensator C3 erweiterte Anregungsschaltung wird durch den Quarz Q gegen Masse abgeschlossen, so daß eine Oszillatorschaltung bei der nominellen Quarzfrequenz entsteht. Damit diese Oszillatorschaltung steuerbar ist, ist in die Verbindung von Quarz Q zum Bezugspotential die Reihenschaltung aus Induktivität L und Varaktordiode D1 als steuerbare Reaktanz eingeschaltet, die bei der Sollfrequenz des Quarzoszillators annähernd den Wert Null hat und bei Verstimmung zu höheren Frequenzen kapazitive und bei Verstimmung zu niedrigeren Frequenzen induktive Werte annimmt. Beim Nominalwert der Steuerspannung am Steuerspannungseingang E bildet diese Serienschaltung also einen Serienresonanzkreis für die Quarzfrequenz.

Entsprechend der Erfindung ist nun zusätzlich ein elektronischer Kurzschließer für die Serienschaltung aus Induktivität L und Varaktordiode D1 angeordnet. Bei einem idealen Kurzschluß ergibt sich ein Festfrequenzbetrieb bei der Sollfrequenz des Quarzes Q, wobei die Veränderung der Reaktanzen der Induktivität L und der Varaktordiode D1 keinen Einfluß auf die Schwingfrequenz haben. Bei geöffnetem elektronischem Kurzschließer kann der Quarzoszillator als spannungsgesteuerter Oszillator betrieben werden, wobei sich aufgrund des gemischt induktiven und kapazitiven Ziehens ein großer Ziehbereich ergibt. Die wesentlichen Elemente dieses schaltbaren elektronischen Kurzschließers sind die beiden Schottkydioden D2 und D3, die über den sechsten Widerstand R6 eine Vorspannung von der negativen Betriebsspannung -UB und über den siebten Widerstand R7 bei eingeschaltetem Transistor T3 von der positiven Betriebsspannung +UB einen positiven Betriebsspannunganteil erhalten. Die Steuerspannung am Steuerspannungseingang E ist so gewählt, daß sie im gesamten Arbeitsbereich mindestens 1 Volt unter dem Massepotential und mindestens 1 Volt über der negativen Betriebsspannung -UB bleibt. Ist in diesem Falle der Transistor T3 stromlos, dann sind die Schottkydioden D2 und D3 mit großer Sicherheit gesperrt, der elektronische Kurzschließer ist also im offenen Schaltzustand. Die Sperrspannung der einen Schottkydiode D2 entspricht dabei der Steuerspannung und die Sperrspannung der Schottkydiode D3 der verbleibenden Differenz zur negativen Betriebsspannung -UB, die über den sechsten Widerstand R6 an der Anode der Schottkydiode D3 anliegt. Die Restströme der Schottkydiode D3 und des dritten Transistors T3 sind dabei so gering, daß sie zu keinem wesentlichen Spannungsabfall am sechsten Widerstand R6 führen. Der parasitäre Blindleitwert des geöffneten Kurzschließers ergibt sich aus der Summe der Sperrschichtkapazitäten der beiden Schottkydioden D2, D3, da diese Dioden aufgrund des vergleichsweise hohen Kapazitätswertes des Abblockkondensators C4 für Wechselspannung parallelgeschaltet sind.

Beim Anlegen einer gegenüber der positiven Betriebsspannung +UB negativeren Einschaltspannung an die Basis des Transistors T3 über den Widerstand R8 wird dieser Transistor eingeschaltet und die Schottkydioden D2, D3 in den Durchlaßbereich gesteuert. Die positive Betriebsspannung +UB und der siebente Widerstand R7 sind dabei so dimensioniert, daß ein Kollektorstrom für den dritten Transistor T3 von einigen Milliampere fließt. Dieser Strom fließt im wesentlichen auch über die Schottkydioden, da die Ströme über den fünften und den sechsten Widerstand R5, R6 aufgrund der vergleichsweise hohen Widerstandswerte vernachlässigbar klein sind. Wegen der geringeren Schwellenspannung der einen Schottkydiode D2 im Vergleich zur Varaktordiode D1 bleibt die letztere dabei praktisch stromlos.

Unter der Voraussetzung, daß der Spitzenwert des Wechselstromes durch den Grundtonquarz Q kleiner als der Durchlaßstrom der beiden Schottkydioden D2, D3 ist, wird die Reihenschaltung aus Induktivität und Varaktordiode, die gleichzeitig die Ziehschaltung für den Quarz darstellt, durch die Parallelschaltung der differenziellen Bahnwiderstände der Schottkydioden D2, D3 kurzgeschlossen. Beim Kollektorstrom des dritten Transistors T3 von etwa drei Milliamper ist in der Praxis der Kurzschlußwiderstand unter 10 Ohm und damit klein gegenüber dem Resonanzwiderstand des verwendeten Quarzes und auch klein gegenüber der Reaktanz der Serienschaltung von Induktivität und Varaktordiode, so daß sich eine vernachlässigbar geringe Verstimmung des Quarzoszillators gegenüber einem idealen Kurzschluß ergibt.

Durch den Transistor T4 und die mit ihm verbundenen Widerstände ergibt sich eine einfache Begrenzer- und Trennstufe für die Auskopplung der Oszillatorspannung.

## Ansprüche

1. Quarzoszillator in Dreipunktschaltung mit gemischt induktiver und kapazitiver Schwingfrequenzsteuerung, bei dem der Emitteranschluß eines ersten Transistors (T1) über eine zur Emitter-Basis-Diode dieses Transistors (T1) entgegengesetzt gepolte Diode (T2) an einen gemeinsamen Verbindungspunkt angeschlossen ist, der über eine Parallelschaltung eines ersten Widerstandes (R1) und eines ersten Kondensators (C1) mit Bezugspotential und über eine Parallelschaltung eines zweiten Widerstandes (R2) und eines zweiten Kondensators (C2) mit dem Basisanschluß des ersten Transistors (T1) verbunden ist, bei dem der Emitteranschluß dieses Transistors (T1) über einen dritten Widerstand (R3) mit einer ersten Betriebsspannung (-UB) und der Kollektoranschluß des ersten Transistors (T1) über einen vierten Widerstand (R4) mit Bezugspotential verbunden ist, bei dem der Steuerspannungseingang für die Schwingfrequenzsteuerung über einen fünften Widerstand (R5) mit einem ersten Anschluß eines frequenzbestimmenden Quarzes (Q) und über die Einschaltung einer Induktivität (L) und einer Varaktordiode (D1) mit Bezugspotential verbunden ist und bei dem die erzeugte Schwingung am Kollektoranschluß des ersten Transistors (T1) ansteht, dadurch gekennzeichnet, daß ein zweiter Anschluß des Quarzes (Q) über einen dritten Kondensator (C3) an die Basis des ersten Transistors (T1) angeschlossen ist, daß Bezugspotential und erste Betriebsspannung (-UB) über die Reihenschaltung einer zweiten und einer dritten jeweils in Sperrichtung gepolten Diode (D2, D3) und eines sechsten Widerstandes (R6) miteinander verbunden sind, daß der Verbindungspunkt der zweiten und der dritten Diode (D2,D3) an den ersten Anschluß des Quarzes (Q) angeschlossen ist, daß der Verbindungspunkt der dritten Diode (D3) und des sechsten Widerstandes (R6) über einen siebenten Widerstand R7 mit dem Kollektor eines dritten Transistors (T3) verbunden ist, daß der Emitter dieses Transistors an eine zweite Betriebsspannung (+UB) und über einen fünften Kondensator (C5) an Bezugspotential angeschlossen ist und daß die Basis des dritten Transistors (T3) über einen achten Widerstand (R8) an eine Schaltspannungsquelle (UC) angeschlossen ist.

2. Quarzoszillator nach Anspruch 1, dadurch gekennzeichnet, daß es sich bei der zweiten und der dritten Diode (D2, D3) um Schottkydioden handelt.

3. Quarzoszillator nach Anspruch 1, dadurch gekennzeichnet, daß es sich bei dem Quarz um einen Grundtonquarz handelt.

4. Quarzoszillator nach einem der vorhergehenden Ansprüche, dadurch gekennzeichnet, daß mit dem Kollektoranschluß des ersten Transistors (T1) über einen sechsten Kondensator (C6) der eine Anschluß eines neunten und eines zehnten Widerstandes und der Basisanschluß eines vierten Transistors (T4) verbunden sind, dessen Emitteranschluß mit dem anderen Anschluß des zehnten Widerstandes (R10) und mit der ersten Betriebsspannung (-UB) verbunden ist, daß der Kollektoranschluß des vierten Transistors (T4) unmittelbar mit dem anderen Anschluß des neunten Widerstandes (R9), über einen siebenten Kondensator (C7) mit dem Ausgangsanschluß (A) und über einen elften Widerstand (R11) mit Bezugspotential verbunden ist.

5. Quarzoszillator nach Anspruch 1 oder 4, dadurch gekennzeichnet, daß als Transistoren (T1,T4) und als Diode (T2) jeweils npn-Transistoren vorgesehen sind, daß erster und zweiter Transistor nach Art einer Stromspiegelschaltung miteinander verbunden sind und daß es sich bei der ersten Betriebsspannung um eine negative Betriebsspannung (-UB) und bei der zweiten Betriebsspannung um eine positive Betriebsspannung (+UB) handelt.

6. Quarzoszillator nach Anspruch 5, dadurch gekennzeichnet, daß die Transistoren (T1,T4) und die Diode (T2) in einem monolithischen Transistorarray enthalten sind.

## Claims

1. Quartz oscillator in a three-point circuit with mixed inductive and capacitive oscillating frequency control, in which the emitter terminal of a first transistor (T1) is connected via a diode (T2) [sic], oppositely poled to the emitter-base diode of this transistor (T1), to a common junction which is connected via a parallel connection of a first resistor (R1) and of a first capacitor (C1) to reference potential and via a parallel connection of a second resistor (R2) and of a second capacitor (C2) to the base terminal of the first transistor (T1), in which the emitter terminal of this transistor (T1) is connected via a third resistor (R3) to a first operating voltage (-UB), and the collector terminal of the first transistor (T1) is connected via a fourth resistor (R4) to reference potential, in which the control voltage input for the oscillating frequency control is connected via a fifth resistor (R5) to a first terminal of a frequency-determining quartz (Q) and via the intermediate connection of an inductance (L) and of a varactor diode (D1) to reference potential, and in which the generated oscillation occurs at the collector terminal of the first transistor (T1), characterized in that a second terminal of the quartz (Q) is connected via a third capacitor (C3) to the base of the first transistor (T1), in that reference potential and first operating voltage (-UB) are connected to one another via the series connection of a second and of a third diode (D2, D3), each poled in the blocking direction, and of a sixth resistor (R6), in that the junction of the second and of the third diode (D2, D3) is connected to the first terminal of the quartz (Q), in that the junction of the third diode (D3) and of the sixth resistor (R6) is connected via a seventh resistor R7 to the collector of a third transistor (T3), in that the emitter of this transistor is connected to a second operating voltage (+UB) and via a fifth capacitor (C5) to reference potential, and in that the base of the third transistor (T3) is connected via an eighth resistor (R8) to a switching voltage source (UC) .

2. Quartz oscillator according to Claim 1, characterized in that the second and the third diode (D2, D3) are Schottky diodes.

3. Quartz oscillator according to Claim 1, characterized in that the quartz is a fundamental crystal.

4. Quartz oscillator according to one of the preceding claims, characterized in that the one terminal of a ninth and of a tenth resistor and the base terminal of a fourth transistor (T4) are connected to the collector terminal of the first transistor (T1) via a sixth capacitor (C6), the emitter terminal of said transistor being connected to the other terminal of the tenth resistor (R10) and to the first operating voltage (-UB), in that the collector terminal of the fourth transistor (T4) is connected directly to the other terminal of the ninth resistor (R9), via a seventh capacitor (C7) to the output terminal (A) and via an eleventh resistor (R11) to reference potential.

5. Quartz oscillator according to Claim 1 or 4, characterized in that in each case npn transistors are provided as transistors (T1, T4) and as diode (T2), in that first and second transistor are connected to one another in the manner of a current reflector circuit, and in that the first operating voltage is a negative operating voltage (-UB) and the second operating voltage is a positive operating voltage (+UB).

6. Quartz oscillator according to Claim 5, characterized in that the transistors (T1, T4) and the diode (T2) are contained in a monolithic transistor array.

## Revendications

1. Oscillateur piézoélectrique en montage de Hartley avec une commande inductive et capacitive mélangée de la fréquence des oscillations, dans lequel la borne d'émetteur d'un premier transistor (T1) est reliée, par l'intermédiaire d'une diode (T2) polarisée en sens inverse par rapport à la diode émetteur - base dudit transistor (T1), à un point de liaison commun qui, par l'intermédiaire d'un montage parallèle d'une première résistance (R1) et d'un premier condensateur (C1), est porté au potentiel de référence et qui, par l'intermédiaire d'un montage série formé par une seconde résistance (R2) et par un second condensateur (C2), est relié à la borne de base du premier transistor (T1), dans lequel la borne d'émetteur de ce transistor (T1) est reliée, par l'intermédiaire d'une troisième résistance (R3), à une première tension de service (-UB), alors que la borne de collecteur du premier transistor (T1) est reliée, par l'intermédiaire d'une quatrième résistance (R4), au potentiel de référence, dans lequel l'entrée de la tension de commande pour la commande de la fréquence des oscillations est reliée, par l'intermédiaire d'une cinquième résistance (R5), à une première borne d'un quartz (Q) qui détermine la fréquence, et par l'intermédiaire du branchement d'une inductance (L) et d'un varactor (D1) (diode à capacité variable), au potentiel de référence, et dans lequel l'oscillation produite est présente à la borne de collecteur du premier transistor (T1), caractérisé par le fait qu'une seconde borne du quartz (Q) est reliée, par l'intermédiaire d'un troisième condensateur (C3), à la base du premier transistor (T1), que le potentiel de référence et la première tension de service (-UB) sont reliés entre eux par l'intermédiaire d'un circuit série formé par une seconde et une troisième diodes (D2, D3) polarisées en direction inverse et par une sixième résistance (R6), que le point de liaison des seconde et troisième diodes (D2, D3) est relié à la première borne du quartz (Q), que le point de liaison entre la troisième diode (D3) et la sixième résistance (R6) est relié, par l'intermédiaire d'une septième résistance (R7), au collecteur d'un troisième transistor (T3), que l'émetteur de ce transistor est relié à une seconde tension de service (+UB) et, par l'intermédiaire d'un cinquième transistor (C5), au potentiel de référence, et que la base du troisième transistor (T3) est reliée, par l'intermédiaire d'une huitième résistance (R8) à une source de tension du montage (UC).

2. Oscillateur piézoélectrique selon la revendication 1, caractérisé par le fait que dans le cas de la seconde et de la troisième diodes (D2, D3) il s'agit de diodes de Schottky.

3. Oscillateur piézoélectrique selon la revendication 1, caractérisé par le fait qu'il s'agit, pour le quartz, d'un quartz à fréquence fondamentale.

4. Oscillateur piézoélectrique selon l'une des revendications précédentes, caractérisé par le fait qu'à la borne de collecteur du premier transistor (T1), et par l'intermédiaire d'un sixième condensateur (C6), sont reliées l'une des bornes d'une neuvième et d'une dixième résistance et la borne de base d'un quatrième transistor (T4), dont la borne d'émetteur est reliée à l'autre borne de la dixième résitance (R10) et avec la première tension de service (-UB), que la borne de collecteur du quatrième transistor (T4) est reliée directement avec l'autre borne de la neuvième résistance (R9), et, par l'intermédiaire d'un septième condensateur (C7), à la borne de sortie (A) et, par l'intermédiaire d'une onzième résistance (R11), avec le potentiel de référence.

5. Oscillateur piézoélectrique selon la revendication 1 ou 4, caractérisé par le fait qu'en tant que transistors (T1, T4) et qu'en tant que diode (T2) on prévoit respectivement des transistors npn, que le premier et le second transistors sont reliés entre eux à la manière d'un circuit à images électriques, et qu'il s'agit, pour la première tension de service d'une tension de service négative (-UB) et pour la seconde tension de service d'une tension de service positive (+UB).

6. Oscillateur piézoélectrique selon la revendication 5, caractérisé par le fait que les transistors (T1, T4) et la diode (T2) sont contenus dans une série de transitors monolythique.